(19) Europäisches Patentamt / European Patent Office / Office européen des brevets

(11) **EP 4 007 092 B1**

## (12) EUROPEAN PATENT SPECIFICATION

(45) Date of publication and mention
of the grant of the patent:
**24.05.2023 Bulletin 2023/21**

(21) Application number: **20210737.1**

(22) Date of filing: **30.11.2020**

(51) International Patent Classification (IPC):
**H01S 5/183** (2006.01)     **H01S 5/42** (2006.01)

(52) Cooperative Patent Classification (CPC):
**H01S 5/18344; H01S 5/423;** H01S 5/18311;
H01S 5/18347

(54) **RADIATION EMITTER**

STRAHLUNGSEMITTER

ÉMETTEUR DE RAYONNEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**01.06.2022 Bulletin 2022/22**

(73) Proprietor: **Changchun Institute of Optics, Fine
Mechanics and
Physics, Chinese Academy of Sciences
Jilin 130033 (CN)**

(72) Inventors:
• **LARISCH, Gunter
15366 Neuenhagen (DE)**

• **TIAN, Sicong
Changchun, Jilin 130033 (CN)**
• **BIMBERG, Dieter
14089 Berlin (DE)**

(74) Representative: **Fischer, Uwe
Patentanwalt
Moritzstraße 22
13597 Berlin (DE)**

(56) References cited:
**CN-B- 106 887 788       US-A1- 2001 043 629
US-A1- 2013 272 330       US-A1- 2016 352 073**

## Description

### Background of the invention

Vertical Cavity Surface Emitting Lasers (VCSELs) are key devices for a rapidly increasing spectrum of systems. It is known, that VCSELs are the dominating light sources for short and medium reach interconnects in workstation clusters or supercomputers due to their large bitrate in concert with a small energy consumption per bit. Both parameters - increase of bitrate and energy consumption (defined by energy to data ratio EDR) - are presently the subjects of large progress. There exists a trade-off between these parameters. The optimal properties of a VCSEL for a given system depends on its bitrate [Larisch et al. Optics Express 28, 6, 2020).

The workload of a workstation cluster or a supercomputer is volatile. Processors are rapidly adapting their performance and energy consumption depending on actual demand. State-of-the-art processors have different cores for different workloads. The operating parameters of a present VCSEL, being the light source of an active optical cable connecting work stations to each other however, cannot be adapted to the varying workload of e.g. a network, a work station cluster,... and is thus operating typically under non-optimum conditions, like larger energy, cooling water, consumption than necessary.

Methods according to the preamble of claim 1 are known in the art in connection with the fabrication of VCSELs.

US Patent Publication 2016/0352073 A1 discloses a VCSEL array having a plurality of VCSELs, each having more than two modes. The optical emission from each of the VCSELs overlaps in a far field of the VCSELs.

US Patent Publication US 2001/0043629 describes a vertical cavity apparatus includes a die with a top surface and a plurality of planar electrically conducting layers. At least one of the layers is an oxide layer formed of an oxidizable material that is oxidized upon exposure to an oxidizing agent to convert the oxidizable material to an electrical insulator.

### Objective of the present invention

In view of the above, an objective of the present invention is, to propose a method for fabricating a multiple radiation emitter that provides novel functionality like being rapidly switchable to optimised conditions with regard to variations of demand.

### Brief summary of the invention

An exemplary embodiment of the present invention relates to a method of fabricating a radiation emitter as defined in claim 1.

Preferred embodiments are defined in the appended dependent claims.

An advantage of this embodiment of the invention is, that the fabricated emitter provides mesa portions that can be addressed individually. The separate mesa portions therefore allow operating the emitter in different light emission modes. For instance, only one or a group of mesa portions may be subjected to an electrical current for active operation whereas one or more other mesa portions may remain inactive. For instance, if the energy efficiency (EDR) for a given bit rate of the mesa portions differ, mesa portions can be selected in view of the bit rate of an external electrical data signal that needs to be optically transmitted (e.g. according to the teaching by Larisch et al. [Optics Express 28, 6, 2020]).

Another advantage of this embodiment of the invention is that mesa portions of the fabricated emitter may have different optical properties for instance regarding the polarization of the output radiation. In this case, polarization multiplexing can be achieved by simultaneously applying different electrical data signals to the mesa portions, still allowing to simply butt couple or focus the optical output into a fiber without any beam combining optics.

The size, i.e. diameter of the mesa, is preferably in the range between 10 and 100 $\mu$m. In this case, the size of the mesa is adapted to the typical diameter (50pm or 62,5 $\mu$m) of the core of a standard multimode fiber and butt-coupling between a standard multimode fiber and the mesa is possible.

The steps of forming the at least two apertures inside the intermediate layers comprises: vertically etching at least six blind holes inside the layer stack, wherein the blind holes vertically extend at least to the lowest intermediate layer and expose the intermediate layers; and oxidizing sections of the intermediate layers via the blind holes and thereby forming said apertures inside the intermediate layers.

Said oxidizing of the intermediate layers is preferably carried out via the sidewalls of the blind holes in lateral direction, wherein from each hole an oxidation front radially moves outwards and wherein the etching is terminated before the entire intermediate layer is oxidized, thereby forming said apertures that are each limited by at least three oxidation fronts.

At least one of the apertures preferably has a rhombus-like shape where each side is formed by a circular or elliptical arc. Rhombus-like shapes may be obtained when four oxidation fronts delimit the aperture.

Additionally, or alternatively at least one of the apertures may have a triangle-like shape where each side is formed by a circular or elliptical arc. Triangle-like shapes may be obtained when three oxidation fronts delimit the aperture.

According to a preferred embodiment, the first aperture is elongated along a first direction, the second aperture is elongated along a second direction, and the first and second direction are angled relative to each other. Angled orientations provide the option of transmitting data signals in a polarization-multiplexing mode.

The longitudinal axis of the first aperture may be oriented perpendicular to the longitudinal axis of the second aperture. A perpendicular orientation allows generating two polarizations at the same time.

Alternatively, the longitudinal axis of the first aperture may have a 60°-angle with respect to the longitudinal axis of the second aperture. A 60°-orientation orientation allows generating three polarizations at the same time.

According to another preferred embodiment in each portion of the mesa preferably at least two apertures are fabricated which have the same orientation. Two or more apertures per mesa portion increase the resulting output power.

According to yet another preferred embodiment, the apertures in the first portion of the mesa may be oriented along the same first direction, and the apertures in the second portion of the mesa are preferably oriented along the same second direction which differs from the first direction.

Said trench may also define a third portion of the mesa in addition to said first and second portion. The apertures in the first portion are preferably oriented along the same first direction. The apertures in the second portion are preferably oriented along the same second direction. The apertures in the third portion are preferably oriented along the same third direction. The first, second and third directions preferably differ.

The first portion of the mesa preferably may be provided with a first optical damping tuning layer that is fabricated on top of the layer stack. The second portion of the mesa may be provided with a second optical damping tuning layer that is fabricated on top of the layer stack. The optical characteristics of the first optical damping tuning layer may differ from the optical characteristics of the second optical damping tuning layer, for instance in order to allow switching between optimum EDRs for a given system bit rate in view of the teaching in the above mentioned publication by Larisch et al. [Optics Express 28, 6,2020].

The layer stack preferably comprises two or more intermediate (oxidizable) layers. At least one of the intermediate layers is preferably formed inside the first reflector or between the first reflector and the active region and at least one of the intermediate layers is preferably formed inside the second reflector or between the second reflector and the active region. One intermediate layer above and one below the active region allows fabricating apertures above and below the active region to provide high current density and high optical output power.

The mesa of the radiation emitter obtained by the method according to the present invention preferably forms a vertical emitting laser (VCSEL).

The mesa preferably has steps.

The emitter obtained by the method according to the present invention preferably comprises a fiber. The mesa including all of the apertures of the mesa is preferably optically coupled (e.g. butt-coupled) to said same fiber.

The cross section and/or diameter of the mesa ring, comprising all apertures, is preferably in the range between 10 and 100 μm in order to be adapted to the diameter of the core of a standard multimode fiber.

Brief description of the drawings

In order that the manner, in which the above-recited and other advantages of the invention are obtained, will be readily understood, a more particular description of the invention briefly described above will be rendered by reference to specific embodiments thereof, which are illustrated in the appended figures.

| | |
|---|---|
| Figures 1-16 | illustrate method steps for fabricating an exemplary embodiment of a radiation emitter, in the form of a VCSEL, according to the present invention, |
| Figures 17-18 | illustrate a second preferred embodiment of a radiation emitter according to the present invention, |
| Figures 19- | illustrate EDR (energy to data ratio) values versus bit-rate for different damping layers, |
| Figures 20-21 | illustrate a third and fourth exemplary embodiment of a radiation emitter according to the present invention, and |
| Figures 22-25 | illustrate method steps for fabricating elongated apertures with orthogonal orientation. |

Detailed description of the preferred embodiments

The preferred embodiments of the present invention will be best understood by reference to the drawings, wherein identical or comparable parts are designated by the same reference signs throughout.

It will be readily understood that the parameters of the embodiments of the present invention, as generally described herein, could vary in a wide range.

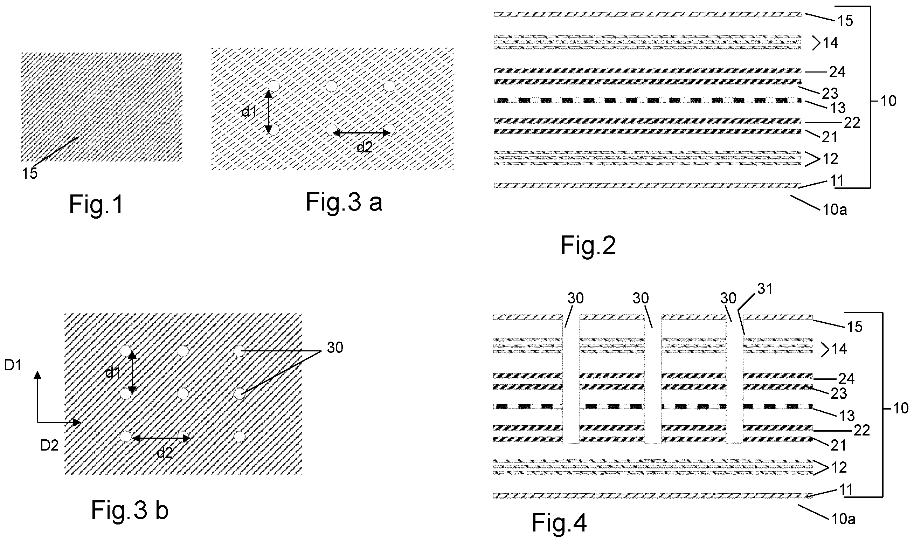

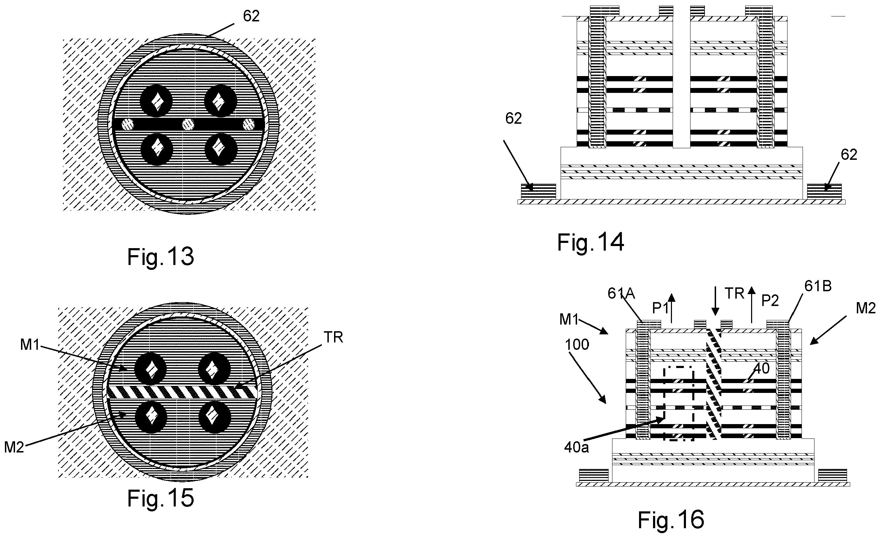

Figures 1-16 show method steps for fabricating a multiple radiation emitter in the form of a VCSEL 100 (see Figure 16) according to the present invention. The VCSEL 100 of Figure 16 comprises two mesa portions M1 and M2 that can be individually controlled via individual top contacts 61A and 61B.

Each of the mesa portions M1 and M2 comprises one or a plurality of VCSEL subunits that are each defined by a stack 40a of vertically aligned apertures 40. Each stack 40a of vertically aligned apertures 40 can generate radiation on its own, however the radiation generated by the stacks 40a is preferably different in each mesa portion M1 and M2 such that each mesa portion M1 and M2 generates a set of own EDR upon transfer of different data rates and/or can show individual optical characteristics, for instance in terms of polarization and field distribution.

Since each of the mesa portions M1 and M2 can be individually controlled, the radiation P1 generated by the stacks 40a of vertically aligned apertures 40 in the mesa portion M1 may differ from the radiation P2 generated by the stacks 40a of vertically aligned apertures 40 in the mesa portion M2.

Figures 1 and 2 show a top view and a cross-section of an layer stack 10 according to a step of the method according to the invention. The layer stack comprises a first (bottom) contact layer 11, a first reflector 12, two intermediate layers 21 and 22, hereinafter referred two as first lower intermediate layer 21 and second lower intermediate layer 22, an active region 13, two intermediate layers 23 and 24, hereinafter referred to as first upper intermediate layer 23 and second upper intermediate layer 24, a second reflector 14, and a second (top) contact layer 15. The four intermediate layers 21-24 consist of oxidizable material which is still unoxidized in Figures 1 and 2.

The first contact layer 11 is preferably highly p-doped (doping level > $10^{19}$ cm$^{-3}$). The second contact layer 15 is preferably highly n-doped (doping level > $10^{19}$ cm$^{-3}$).

The first and second reflectors 12 and 14 may be distributed Bragg reflectors (DBRs) that each comprise a plurality of reflector layers with alternating reflective indices.

The layer stack 10 is preferably fabricated by depositing semiconductor material layers such as Al-GaAs, of varying composition, on a substrate 10a.

In the embodiment of Figure 2, which corresponds to a step of the method according to the invention two intermediate layers 21-22 are located below the active region 13 and two intermediate layers 23-24 are located above the active region 13. In other preferred embodiments, the layer stack 10 may comprise less or more intermediate layers that are oxidizable. In a minimal configuration, a single intermediate layer is sufficient. However, to provide a high current density in the active region 13, at least one intermediate layer above and at least one intermediate layer below the active region 13 is advantageous.

Figures 3a and b and 4 show a top view and a cross-section of the layer stack 10 of Figures 1 and 2 after vertically etching 6, respectively 9 blind holes 30 inside the layer stack 10. The blind holes 30 vertically protrude to the oxidizable intermediate layers 21-24 and expose the intermediate layers 21-24.

In the exemplary embodiment of Figures 3, the blind holes 30 are arranged in a lattice-like way forming a grid having a first grid spacing d1 in a first direction D1 and a second grid spacing d2 in a second different direction D2.

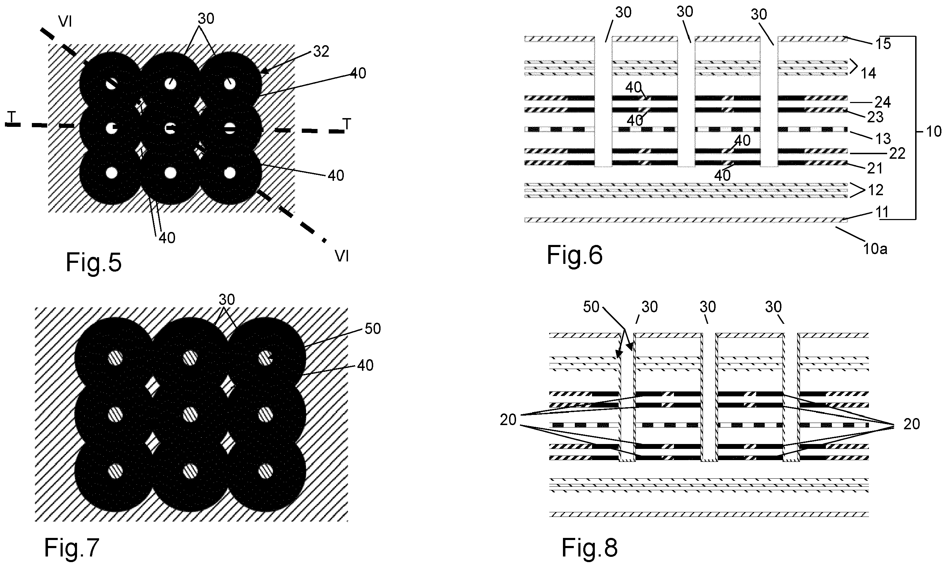

In one preferred embodiment, the first grid spacing d1 and the second grid spacing d2 are identical. In another preferred embodiment, the first grid spacing d1 is between 10% and 30% larger than the second grid spacing d2. Furthermore, the first and second direction D1, D2 can be perpendicular. Alternatively, the first and second direction D1, D2 can be angled, preferably with an angle between 60° and 85°. The grid spacing and/or directions may be optimized to achieve a desired shape (e.g. elongated) shape of the resulting apertures 40 (see Figure 5).

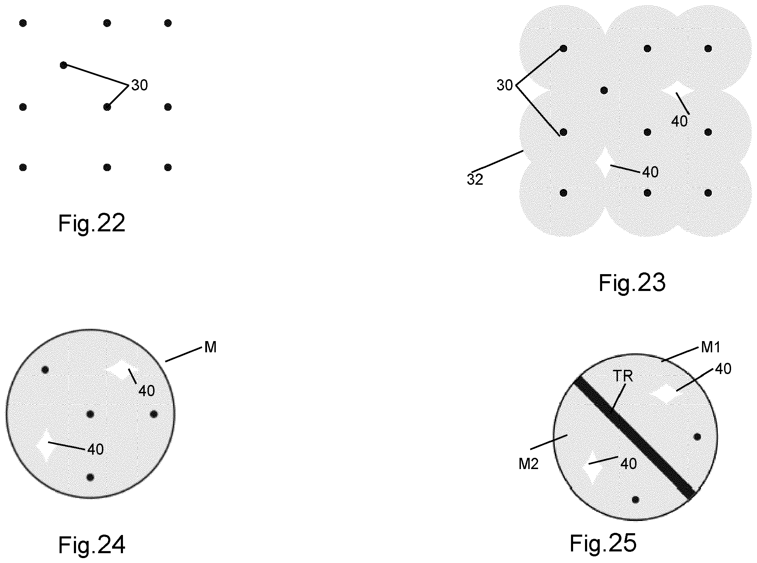

Further, the holes 30 may be arranged such that the resulting apertures 40 are elongated in predefined directions, with the same orientation for each aperture or varying orientations. Such arrangements of blind holes 30 will be explained further below in connection with Figures 22-25.

Figures 5 and 6 show the layer stack 10 of Figures 3b and 4 after oxidizing the oxidizable intermediate layers 21-24 via the sidewalls 31 of the blind holes 30 in lateral direction. From each blind hole 30, an oxidation front radially (in lateral direction) moves outwards during the oxidation. The step of etching is terminated before the entire intermediate layers 21-24 are oxidized to form unoxidized apertures 40. Each unoxidized aperture 40 is preferably limited by at least three oxidation fronts of oxidized layer material 20. In the exemplary embodiment of Figure 5, each unoxidized aperture 40 is limited by four oxidation fronts 32 of oxidized layer material 20 and therefore has a diamond-like shape.

The unoxidized apertures 40 are vertically aligned and form aperture stacks 40a (see Figure 16) of vertically aligned apertures. Since the layer stack 10 comprises four intermediate layers 21-24, each aperture stack comprises four vertically aligned apertures 40. Each aperture stack 40a of vertically aligned apertures 40 forms a VCSEL subunit inside the VSEL 100 of Figure 16.

The oxidized layer material 20 is preferably electrically isolating.

In Figure 5, line VI-VI designates the cross-section shown in Figure 6. Line T-T designates the position of a trench TR (see Figures 15 and 16) that will be fabricated at a later stage.

Figures 7 and 8 show the layer stack 10 of Figure 6 after depositing an intermediate isolating layer 50 on the sidewalls of the blind holes 30. The sidewalls of all the blind holes 30 may be covered as shown in Figures 7 and 8. Alternatively, those blind holes that are located on line T-T in Figure 5 may be excluded from deposition because they are located in the vicinity of the future trench TR mentioned above.

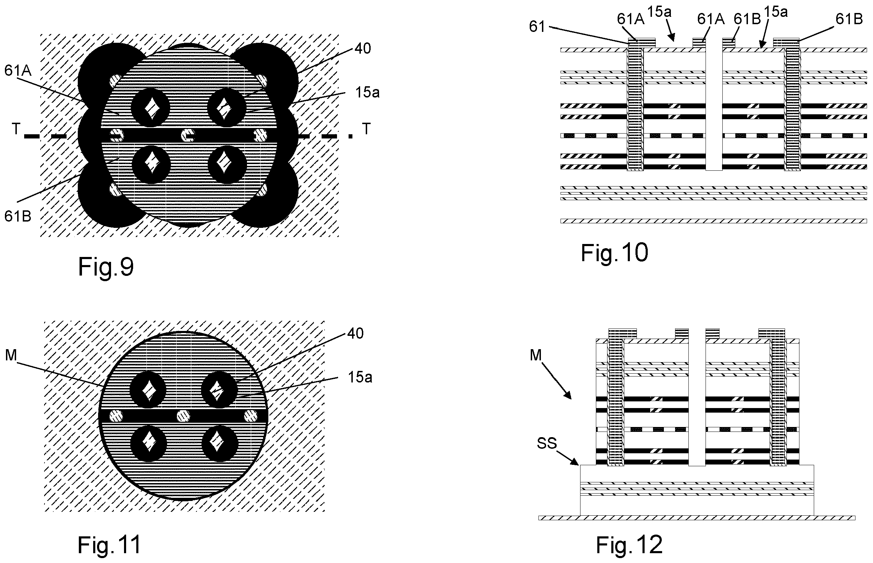

Figures 9 and 10 show a preferred embodiment, which shows the layer stack 10 of Figure 8 after depositing a first conducting material 61 on the top contact layer 15. The first conducting material 61 covers sections of the top contact layer 15 and forms two separated top contacts 61A and 61B. The top contacts 61A and 61B are separated along the line T-T in Figures 5 and 9.

Sections 15a of the top contact layer 15 above the apertures 40 are preferably left uncovered to allow the optical radiation P1 and P2 (see Figure 16) to exit the radiation emitter 100 without additional attenuation. In other words, the two separate top contacts 61A and 61B preferably provide openings for outgoing radiation. The openings are preferably each aligned with the allocated apertures 40 located below. In other words, the apertures below each opening are preferably aligned with respect to the opening as well as to one another in order to form a stack 40a of aligned apertures 40 that is aligned to the allocated opening (see Figure 16).

In addition to its electrical influence, the first conducting material 61 preferably also forms a heat sink that dissipates heat from the inside of the blind holes during the operation of the resulting radiation emitter 100. To this end, the first conducting material 61 preferably also fills the blind holes 30 that are not located in the vicinity of line T-T in Figures 5 and 9. The first conducting material 61 is therefore preferably not just electrically but also thermally well conductive. The conducting material 61 is preferably Gold, Platinum, Titanium, Nickel, Gold-Germanium alloy or a sequence of these materials, depending on the doping type of the semiconductor material that is to be contacted.

Figures 11 and 12 show the layer stack 10 of Figures 9 and 10 after etching a mesa M inside the layer stack 10. The mesa M may have one or more steps SS. The mesa M preferably extends to the bottom contact layer 11 to allow depositing a second conductive material 62, see Fig. 14, and thereby contacting the bottom contact layer 11.

Figures 13 and 14 show the layer stack 10 of Figures 11 and 12 after depositing the second conductive material 62 and contacting the bottom contact layer 11.

Figures 15 and 16 show the layer stack 10 of Figures 13 and 14 after etching above mentioned trench TR inside the layer stack 10 along the line T-T. The trench TR defines a first portion M1 of the mesa M and a second portion M2 of the mesa M. The trench TR severs all the intermediate layers 21-24 such that the apertures 40 are either located below the openings of the first contact 61A or the openings of the second contact 61B.

The trench may be filled with an electrically isolating material having preferably large thermal conductivity and a low dielectric constant (refractive index < 2,2).

The layer stack 10 of Figures 15 and 16 provide a radiation emitter that comprises two laser sections that are each defined by the respective mesa portion M1 or M1. The mesa portions M1 and M2 can be individually controlled.

When applying an electrical voltage between the first and second conducting material 61 and 62 via top contacts 61A and/or 61B, electrical current will flow through the apertures 40 of all oxidizable layers 21-24 in the respective mesa portion M1 and/or M2. The active region 13 generates optical radiation that exits the radiation emitter 100 through the surface sections 15a of the top conducting layer 15 that are uncovered by the first conductive material 61.

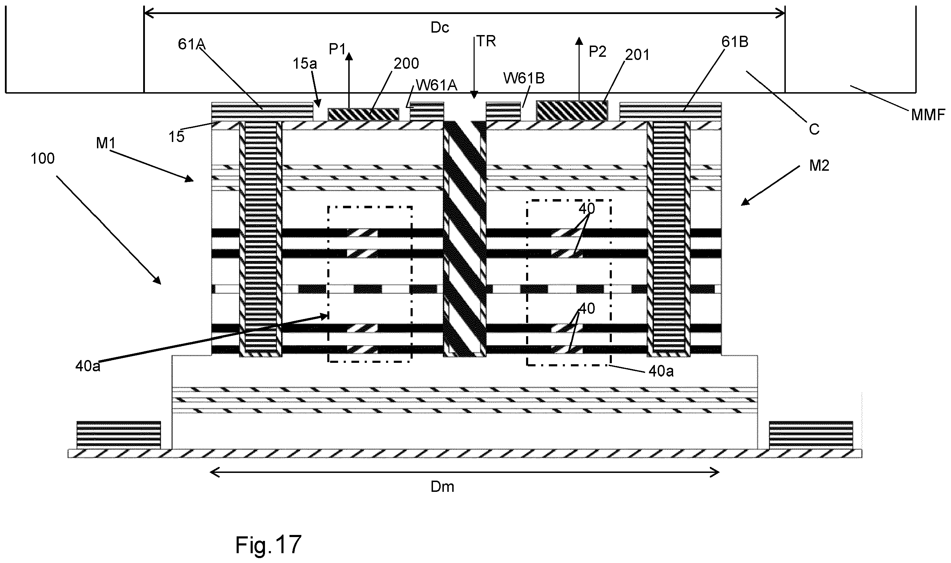

In each of the mesa portions M1 and M2, each of the apertures 40 in combination with the adjacent section of the active region 13 may be regarded as an individual VCSEL unit. Therefore, the radiation emitter 100 comprises a plurality of these individual VCSEL units. The individual VCSEL units are narrowly spaced such that their radiation can be coupled into the same optical fiber (e.g. multimode fiber MMF as shown in Figure 17).

Figure 17 depicts a second exemplary embodiment of a radiation emitter 100 according to the present invention. In contrast to the first embodiment according to Figure 16, the second embodiment comprises a first and a second damping tuning layer 200 and 201. The damping tuning layers 200 and 201 are deposited on top of the layer stack 10, preferably after fabricating the top contacts 61A and 61B.

The first optical damping tuning layer 200 is located on the first portion M1 of the mesa M. In the embodiment of Figure 17, the first optical damping tuning layer 200 is arranged only on top of the uncovered sections 15a of the first top contact layer 15, i.e. inside the openings or windows W61A of the first top contact 61A. Alternatively, the first optical damping tuning layer 200 may also completely or partly cover the top contact 61A.

The second optical damping tuning layer 201 is located on the second portion M2 of the mesa M. In the embodiment of Figure 17, the second optical damping tuning layer 201 is arranged on top of the uncovered sections 15a of the top contact layer 15, i.e. inside the openings or windows W62A of the second top contact 61B. Alternatively, the second optical damping tuning layer 201 may also completely or partly cover the top second contact 61B.

The optical characteristics of the first optical damping tuning layer 200 differs from the optical characteristics of the second optical damping tuning layer 201. For instance, the thicknesses of the layers may differ as shown in Figure 17. Additional or alternatively, the materials of the layers may differ.

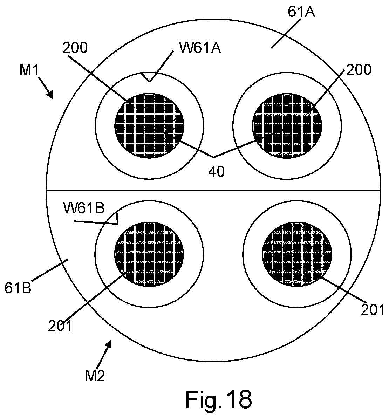

Figure 18 depicts a top view of the second embodiment of Figure 17 showing two emitters for each portion of the mesa. In this second embodiment of Figures 17 and 18, the optical damping tuning layers 200 and 201 may be optimized for maximum energy efficiency at a given bitrate. For instance, the first mesa portion M1 may be optimized to achieve largest energy-efficient bitrate via low damping. In contrast, the second mesa portion M2 may be optimized to dissipate a minimum energy per bit at a medium bitrate. Depending on external requirements, either the first mesa portion M1 or the second mesa portion M2 may be operated to generate optical radiation.

In the embodiments shown in Figures 16 and 17, the cross section and diameter Dm of the mesa M is preferably in the range between 10 and 100 μm in order

to be adapted to the diameter Dc of the core C of a standard multimode fiber MMF (typical core diameter Dc usually 50 or 65 $\mu$m). Such a dimension Dm of the mesa M allows both mesa portions M1 and M2 to efficiently couple their emissions into the same multimode fiber MMF. The multimode fiber MMF is preferably butt-coupled to the mesa M and its mesa portions M1 and M2 as shown on Figure 17.

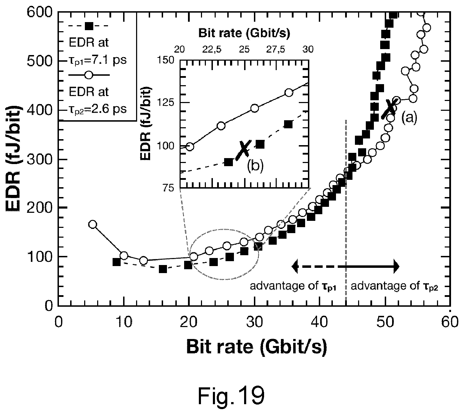

Figure 19 shows EDR versus bitrate calculated from the small-signal response of mesa portions with different damping properties. Each mesa portion can be optimized for one target bitrate.

As a result, a two-portion mesa emitter can be optimized for two target bit-rate areas, as shown in Figure 19. The two-portion mesa emitter can be switched to the optimum EDR for a given target bit-rate area because switching changes the properties of the emitter.

In the first and second preferred embodiments according to Figures 16 and 17, each mesa portion M1 and M2 comprises two apertures 40. Alternatively, the mesa portions may comprise more or less apertures 40.

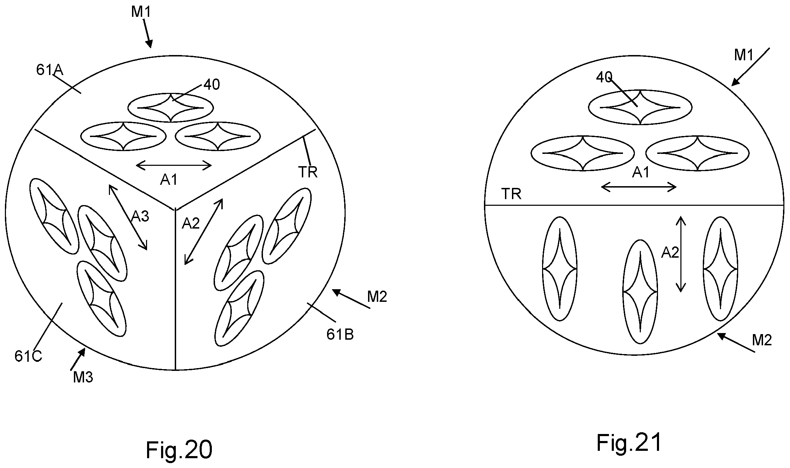

In the first and second preferred embodiments according to Figures 16 and 17/18, the size, contour and orientation of all apertures 40 are identical. Alternatively, the size, contour and orientation of the apertures 40 may vary as will be discussed further below in connection with Figures 20 to 24.

Figure 20 depicts a schematic top view of a third preferred embodiment of a radiation emitter according to the present invention. In contrast to the embodiments according to Figures 16 and 17, the mesa in Figure 20 comprises three mesa portions M1, M2 and M3 which are each provided with a separate top contact 61A, 61B and 61C. Via the allocated top contacts 61A, 61B and 61C, the three mesa portions M1, M2 and M3 may be operated individually, i.e. in parallel or consecutively, e.g. in individually assigned time frames.

In the embodiment of Figure 20, the apertures 40 in each mesa portion M1, M2 and M3 are elongated along the same "portion-assigned" longitudinal direction A1, A2 or A3. More specifically, each mesa portion has its individually assigned orientation. The orientation of the apertures 40 in the first portion M1 and their longitudinal direction A1 has an angle of 60° with respect to the orientation of the apertures 40 in the second portion M2 and their longitudinal direction A2.

The orientation of the apertures 40 in the second portion M2 and their longitudinal direction A2 has an angle of 60° with respect to the orientation of the apertures 40 in the third portion M3 and their longitudinal direction A3. Therefore, the orientation of the apertures 40 in the third portion M3 and their longitudinal direction A3 also has an angle of 60° with respect to the orientation of the apertures 40 in the first portion M1 and their longitudinal direction A1.

In other words, the longitudinal directions A1, A2 and A3 have an angle of 60° with respect to one another.

The elongated shape of the apertures 40 may lead to a polarized emission of radiation such that each mesa portion M1, M2 and M3 emits radiation with a specific polarization. Since the mesa portions M1, M2 and M3 may be individually operated, radiation with different polarizations may be generated simultaneously and polarization multiplexing may be carried out to increase the link capacity.

Figure 21 depicts a fourth preferred embodiment of a radiation emitter according to the invention. In contrast to embodiments according to Figure 20, the mesa of Figure 21 comprises two mesa portions M1 and M2 in which the apertures 40 are elongated along the same "portion-assigned" longitudinal direction A1 and A2. More specifically, each mesa portion M1 and M2 has its individually assigned orientation. The longitudinal directions A1 and A2 have an angle of 90° with respect to each other.

Since the elongated shape of the apertures 40 may lead to a polarized emission of radiation and since the mesa portions M1 and M2 may be individually operated, radiation with two different polarizations may be generated simultaneously and polarization multiplexing may be carried out in order to increase the link capacity.

Figures 22-25 show preferred additional method steps of fabricating apertures with different orientations.

Figure 22 shows a grid of holes 30. The distribution of the holes 30 leads to two apertures having similar shape but different orientation enabling the emission of polarized light as discussed above with respect to Figures 20 and 21.

The holes 30 can be etched by a chloric acid based dry etching process. Depending on the process parameters like temperature and gas flow, the oxidation speed can also depend on the crystal axes, becoming anisotropic thus also affecting the shape of the resulting apertures 40.

The distances between the holes 30 and the size of the holes 30 can be chosen to position a sufficient number of apertures 40 so close to each other that the light emission can be coupled into e.g. a 50 $\mu$m or 62.5 $\mu$m core of a multimode fiber MMF as discussed above with reference to Figures 16 and 17

Figure 23 shows the resulting apertures 40 based on an isotropic oxidation that yields circular oxidation fronts 32. The oxidation is stopped after two diamond-shaped apertures 40 with a 90° orientation difference have been formed.

Figure 24 shows the resulting structure after etching the mesa M.

Etching a trench TR at least down to the lowest oxidizable intermediate layer 21 underneath the active region 13 (see Figure 2) separates the mesa M into several portions M1 and M2, which can be pumped independently to each other as discussed above.

In summary the embodiments described above relate to a method for fabricating a vertical-cavity surface-emitting laser (VCSEL) as radiation emitter 100 with multiple apertures 40 narrowly spaced in separate mesa portions M1, M2 and/or M3 of the same single mesa M. The mesa portions M1-M3 may be operated simultaneously, for instance by way of polarization multiplexing to increase the link capacity. Alternatively, the mesa portions M1-M3 may be operated alternatively, for instance to choose minimum EDR for varying bitrates.

The fabrication of the VCSEL 100 may be based on etching of narrow holes 30, e.g. 5 $\mu$m or less, in a regular array of a few $\mu$m distance between each hole into VCSEL wafers containing for instance AlGaAs (preferentially about 98% Al-contents) aperture layers. The arrangement of the holes 30 with respect to each other is variable and application dependent, for instance to generate specific shapes (e.g. elongated) and/or specific orientations of the resulting apertures.

The oxidation of the e.g. AlO apertures 40 is progressing from the inside of the holes 30. The orientation of the axes of the hole-arrays can be varied with respect to the crystal axes, thus leading to self-limiting orientation dependent oxidation processes. The novel VCSEL properties, including increased output power, defined EDR and polarization, enable data transmission across large fiber distances ~ 1km at increased bit rates, reduced energy consumption and more.

The embodiments of the invention described above may have one or more of the following features and/or advantages:

- Preferred embodiments of the invention may relate to a method for fabricating a vertical-cavity surface-emitting laser (VCSEL) with multiple apertures narrowly spaced in a single mesa M that may result e.g. in single mode emission together with large optical output power and small electrical resistance.
- Preferred embodiments of the invention may consist of an active region sandwiched between two distributed Bragg reflectors (DBRs) and at least one oxide layer like a "normal" VCSEL structure. Any presently existing epi structure for high-speed oxide confined VCSELs can be used for the inventive approach. In contrast to presently employed VCSEL processing, the oxidation process may be based on etching holes of any shape into the wafer surface, exposing the oxide layer(s). These holes are serving as starting point for the lateral oxidation process.
- The speed of the wet oxidation of the oxidizable layer(s) 21-24 may depend on Al-contents, AlGaAs layer thickness, and most importantly on the crystallographic direction. In addition, it is controlled e.g. by temperature, total pressure, and water partial pressure.
- The arrangement of the etched holes in respect to each other and to the crystal axes, the distances between them, and finally the choice of the oxidation parameters impacts the shape of the resulting apertures and opens new design roads. The oxidation fronts may be circular or elliptical. The resulting apertures may have a diamond shape.
- The final processing step may comprise mesa M etching, n-contact deposition, and planarization based on the processing steps developed for "normal" VCSELs.
- GaAs/AlAs heterostructures are enabling the growth of lattice matched DBRs and high Al-content layers suitable for wet oxidation and leading to current and optical field confinement. The apertures will not be oxidized from the outside after etching a mesa M, but from the inside of holes, being first etched in regular arrays.
- The arrangement of the blind holes with respect to each other and to the crystal axes presents a free design parameter. The resulting apertures however may have always the same size. A difference in distance of the holes in one direction and the other direction may lead to a difference in oxide diameter in both directions and may allow polarized emission if desired.
- The oxidation speed depends on the crystal axes. The impact on the shape of the oxidation front has an impact on the shape of the resulting apertures.
- The alignment between the series of holes defined by the mask and the crystal axes may enable a shape optimization of the oxide confined apertures and allows to control the polarization status of the emitted light.
- The distances between the holes (d1 in one direction and d2 in the other direction) and the size of the holes can be chosen to position a sufficient number of apertures so close to each other, that additionally the emitted light emission can be coupled into e.g. the 50 or 62,5 $\mu$m core of a multimode fiber (MMF) preferably without coupling optics.
- The optical power increases linearly with the number of apertures. If the size of the apertures is chosen in such a way that the laser emits single mode light, the intensity increases with the number of apertures, showing identical wavelength, polarization and transverse mode. The electrical resistance decreases similarly with the number of apertures. The total resistance $R_t$ can be calculated by

$$\frac{1}{R_t} = \sum_{x=1}^{n} \frac{1}{R_x}$$

With the resistance Rx of an individual aperture.

The various embodiments and preferred embodiments of the invention disclosed herein are to be understood not only in the order and context specifically described in this specification, but to include any order and any combination thereof. Whenever the context requires, all words used in the singular number shall be deemed to include the plural and vice versa. Whenever the context requires, all options that are listed with the word "and" shall be deemed to include the word "or" and vice versa, and any combination thereof.

**Claims**

1. Method of fabricating a radiation emitter (100) comprising the steps of

   fabricating a layer stack (10) that comprises a first reflector (12), at least one intermediate layer (21-24), an active region (13), and a second reflector (14);
   locally oxidizing the at least one intermediate layer (21-24) and thereby forming at least one unoxidized aperture (40) in the at least one intermediate layer (21-24); and
   locally removing the layer stack (10), and thereby forming a mesa (M), wherein the mesa (M) comprises the first reflector (12), the at least one unoxidized aperture (40), the active region (13), and the second reflector (14); wherein

   before or after locally removing the layer stack (10) and forming the mesa (M) the following steps are carried out:
   vertically etching blind holes (30) inside the layer stack, wherein the blind holes (30) vertically extend at least to the intermediate layer (21-24) and expose the intermediate layer (21-24); wherein said step of locally oxidizing sections of the at least one intermediate layer (21-24) via the blind holes (30) forms at least a first unoxidised aperture (40) and a second unoxidised aperture (40) inside the at least one intermediate layer (21-24); and
   etching a trench (TR) inside the layer stack (10), said trench (TR) defining at least a first portion (M1) of the mesa (M) and at least a second portion (M2) of the mesa (M), wherein the trench (TR) severs the intermediate layer (21-24) and separates the apertures (40) such that the at least one first aperture (40) is located in the first portion (M1) of the mesa (M) and the at least one second aperture (40) is located in the second portion (M1) of the mesa (M); and
   fabricating an individual electrical contact (61A, 61B) for each of the portions (M1, M2).

2. Method of claim 1
   wherein said oxidizing of the intermediate layer (21-24) is carried out via the sidewalls (31) of the blind holes (30) in lateral direction, wherein from each hole (30) an oxidation front (32) radially moves outwards and wherein the etching is terminated before the entire intermediate layer (21-24) is oxidized, thereby forming said apertures (40) that are each limited by at least three oxidation fronts.

3. Method according to any of the preceding claims wherein at least one of the apertures (40) has a rhombus-like shape where each side is formed by a circular or elliptical arc.

4. Method according to any of the preceding claims wherein at least one of the apertures (40) has a triangle-like shape where each side is formed by a circular or elliptical arc.

5. Method according to any of the preceding claims

   wherein the at least one first aperture (40) is elongated along a first direction (A1);
   wherein the at least one second aperture (40) is elongated along a second direction (A2); and
   wherein the first and second direction (A1, A2) are angled relative to each other.

6. Method according to claim 5 wherein
   the longitudinal axis of the first aperture (40) is oriented perpendicular to the longitudinal axis of the second aperture (40).

7. Method according to claim 5 wherein
   the longitudinal axis of the first aperture (40) has a 60°-angle with respect to the longitudinal axis of the second aperture (40).

8. Method according to any of the preceding claims wherein
   in each portion (M1) of the mesa (M) at least two apertures (40) are fabricated which have the same orientation.

9. Method according to any of the preceding claims

   wherein the apertures (40) in the first portion (M1) of the mesa (M) are oriented along the same first direction (A1); and
   wherein the apertures (40) in the second portion (M2) of the mesa (M) are oriented along the same second direction (A2) which differs from the first direction (A1).

10. Method according to any of the preceding claims

    wherein said trench (TR) defines a third portion (M3) of the mesa (M) in addition to said first and second portion (M1, M2),
    wherein the apertures (40) in the first portion (M1) are oriented along the same first direction (A1);

wherein the apertures (40) in the second portion (M2) are oriented along the same second direction (A2);

wherein the apertures (40) in the third portion (M3) are oriented along the same third direction (A3); and

wherein the first, second and third directions differ.

11. Method according to any of the preceding claims

wherein the first portion (M1) of the mesa (M) is provided with a first optical damping tuning layer (200) that is fabricated on top of the layer stack (10);

wherein the second portion (M1) of the mesa (M) is provided with a second optical damping tuning layer (210) that is fabricated on top of the layer stack (10); and

wherein the characteristics of the first optical damping layer differs from the characteristics of the second optical damping layer.

12. Method according to any of the preceding claims

wherein the layer stack (10) comprises two or more intermediate layers (21-24);

wherein at least one of the intermediate layers (21-24) is formed inside the first reflector or between the first reflector and the active region (13) and

wherein at least one of the intermediate layers (21-24) is formed inside the second reflector or between the second reflector and the active region (13).

13. Method according to any of the preceding claims wherein the mesa (M) including all apertures (40) of the mesa (M) is optically coupled to one and the same fiber (MMF).

**Patentansprüche**

1. Verfahren zur Fertigung eines Strahlungsemitters (100), umfassend die Schritte:

Fertigen eines Schichtstapels (10), der einen ersten Reflektor (12), mindestens eine Zwischenschicht (21-24), eine aktive Region (13) und einen zweiten Reflektor (14) umfasst;

lokales Oxidieren der mindestens einen Zwischenschicht (21-24) und dadurch Bilden von mindestens einer nicht-oxidierten Öffnung (40) in der mindestens einen Zwischenschicht (21-24); und

lokales Entfernen des Schichtstapels (10), und dadurch Bilden einer Mesa (M), wobei die Mesa (M) den ersten Reflektor (12), die mindestens eine nicht-oxidierte Öffnung (40), die aktive Region (13) und den zweiten Reflektor (14) umfasst;

wobei vor oder nach dem lokalen Entfernen des Schichtstapels (10) und Bilden der Mesa (M) die folgenden Schritte ausgeführt werden:

vertikales Ätzen von Sacklöchern (30) in den Schichtstapel, wobei die Sacklöcher (30) sich vertikal mindestens zu der Zwischenschicht (21-24) erstrecken und die Zwischenschicht (21-24) exponieren; wobei der Schritt des lokalen Oxidierens von Abschnitten der mindestens einen Zwischenschicht (21-24) mittels der Sacklöcher (30) mindestens eine erste nicht-oxidierte Öffnung (40) und eine zweite nicht-oxidierte Öffnung (40) innerhalb der mindestens einen Zwischenschicht (21-24) bildet; und

Ätzen eines Grabens (TR) in den Schichtstapel (10), wobei der Graben (TR) mindestens einen ersten Anteil (M1) der Mesa (M) und mindestens einen zweiten Anteil (M2) der Mesa (M) definiert, wobei der Graben (TR) die Zwischenschicht (21-24) durchschneidet und die Öffnungen (40) so trennt, dass die mindestens erste Öffnung (40) sich in dem ersten Anteil (M1) der Mesa (M) befindet und die mindestens eine zweite Öffnung (40) sich in dem zweiten Anteil (M1) der Mesa (M) befindet; und

Fertigen eines individuellen elektrischen Kontakts (61A, 61B) für jeden der Anteile (M1, M2).

2. Verfahren nach Anspruch 1, wobei das Oxidieren der Zwischenschicht (21-24) mittels der Seitenwände (31) der Sacklöcher (30) in lateraler Richtung durchgeführt wird, wobei sich von jedem Loch (30) eine Oxidationsfront (32) radial auswärts bewegt, und wobei das Ätzen beendet wird, bevor die gesamte Zwischenschicht (21-24) oxidiert ist, wodurch die Öffnungen (40) gebildet werden, die jeweils durch mindestens drei Oxidationsfronten begrenzt sind.

3. Verfahren nach einem der vorhergehenden Ansprüche, wobei mindestens eine der Öffnungen (40) eine rautenartige Form hat, wobei jede Seite durch einen kreisförmigen oder elliptischen Bogen gebildet ist.

4. Verfahren nach einem der vorhergehenden Ansprüche, wobei mindestens eine der Öffnungen (40) eine dreieckartige Form hat, wobei jede Seite durch einen kreisförmigen oder elliptischen Bogen gebildet ist.

**5.** Verfahren nach einem der vorhergehenden Ansprüche, wobei die mindestens eine erste Öffnung (40) entlang einer ersten Richtung (A1) länglich ist; wobei die mindestens eine zweite Öffnung (40) entlang einer zweiten Richtung (A2) länglich ist; und wobei die erste und die zweite Richtung (A1, A2) relativ zueinander gewinkelt sind.

**6.** Verfahren nach Anspruch 5, wobei die Längsachse der ersten Öffnung (40) senkrecht zu der Längsachse der zweiten Öffnung (40) orientiert ist.

**7.** Verfahren nach Anspruch 5, wobei die Längsachse der ersten Öffnung (40) einen Winkel von 60° in Bezug zu der Längsachse der zweiten Öffnung (40) hat.

**8.** Verfahren nach einem der vorhergehenden Ansprüche, wobei in jedem Anteil (M1) der Mesa (M) mindestens zwei Öffnungen (40) gefertigt sind, welche die gleiche Orientierung haben.

**9.** Verfahren nach einem der vorhergehenden Ansprüche, wobei die Öffnungen (40) in dem ersten Anteil (M1) der Mesa (M) entlang der gleichen ersten Richtung (A1) orientiert sind; und wobei die Öffnungen (40) in dem zweiten Anteil (M2) der Mesa (M) entlang der gleichen zweiten Richtung (A2) orientiert sind, die sich von der ersten Richtung (A1) unterscheidet.

**10.** Verfahren nach einem der vorhergehenden Ansprüche, wobei der Graben (TR) einen dritten Anteil (M3) der Mesa (M) zusätzlich zu dem ersten und dem zweiten Anteil (M1, M2) definiert,

wobei die Öffnungen (40) in dem ersten Anteil (M1) entlang der gleichen ersten Richtung (A1) orientiert sind; wobei die Öffnungen (40) in dem zweiten Anteil (M2) entlang der gleichen zweiten Richtung (A2) orientiert sind; wobei die Öffnungen (40) in dem dritten Anteil (M3) entlang der gleichen dritten Richtung (A3) orientiert sind; und wobei sich die erste, zweite und dritte Richtung unterscheiden.

**11.** Verfahren nach einem der vorhergehenden Ansprüche, wobei der erste Anteil (M1) der Mesa (M) mit einer ersten optischen Dämpfungsabstimmschicht (200) ausgestattet ist, die oben auf dem Schichtstapel (10) gefertigt ist;

wobei der zweite Anteil (M1) der Mesa (M) mit einer zweiten optischen Dämpfungsabstimmschicht (210) ausgestattet ist, die oben auf dem Schichtstapel (10) gefertigt ist; und wobei die Charakteristika der ersten optischen Dämpfungsschicht sich von den Charakteristika der zweiten optischen Dämpfungsschicht unterscheiden.

**12.** Verfahren nach einem der vorhergehenden Ansprüche, wobei der Schichtstapel (10) zwei oder mehr Zwischenschichten (21-24) umfasst;

wobei mindestens eine der Zwischenschichten (21-24) in dem ersten Reflektor oder zwischen dem ersten Reflektor und der aktiven Region (13) gebildet ist, und wobei mindestens eine der Zwischenschichten (21-24) in dem zweiten Reflektor oder zwischen dem zweiten Reflektor und der aktiven Region (13) gebildet ist.

**13.** Verfahren nach einem der vorhergehenden Ansprüche, wobei die Mesa (M) einschließlich aller Öffnungen (40) der Mesa (M) optisch an ein und dieselbe Faser (MMF) gekoppelt ist.

**Revendications**

**1.** Procédé de fabrication d'un émetteur de rayonnement (100) comprenant les étapes de

fabrication d'un empilement de couches (10) qui comprend un premier réflecteur (12), au moins une couche intermédiaire (21-24), une région active (13), et un deuxième réflecteur (14) ; oxydation locale de l'au moins une couche intermédiaire (21-24) et de ce fait formation d'au moins une ouverture non oxydée (40) dans l'au moins une couche intermédiaire (21-24) ; et retrait local de l'empilement de couches (10), et de ce fait formation d'une mesa (M), la mesa (M) comprenant le premier réflecteur (12), l'au moins une ouverture non oxydée (40), la région active (13), et le deuxième réflecteur (14) ; dans lequel, avant ou après le retrait local de l'empilement de couches (10) et la formation de la mesa (M), les étapes suivantes sont réalisées :

gravure verticale de trous borgnes (30) à l'intérieur de l'empilement de couches, les trous borgnes (30) s'étendant verticalement au moins jusqu'à la couche intermédiaire (21-24) et exposant la couche intermédiaire (21-24) ; ladite étape d'oxydation locale de sections de l'au moins une couche intermédiaire (21-24) par le biais des trous borgnes (30) formant au moins une première ouverture non oxydée (40) et une deuxième ouverture non oxydée (40) à l'intérieur de l'au moins une couche intermédiaire (21-24) ; et

gravure d'une tranchée (TR) à l'intérieur de l'empilement de couches (10), ladite tranchée (TR) définissant au moins une première portion (M1) de la mesa (M) et au moins une deuxième portion (M2) de la mesa (M), la tranchée (TR) coupant la couche intermédiaire (21-24) et séparant les ouvertures (40) de telle sorte que l'au moins une première ouverture (40) est située dans la première portion (M1) de la mesa (M) et l'au moins une deuxième ouverture (40) est située dans la deuxième portion (M1) de la mesa (M) ; et

fabrication d'un contact électrique individuel (61A, 61B) pour chacune des portions (M1, M2).

2. Procédé de la revendication 1
dans lequel ladite oxydation de la couche intermédiaire (21-24) est réalisée par le biais des parois latérales (31) des trous borgnes (30) dans une direction latérale, dans lequel, depuis chaque trou (30), un front d'oxydation (32) se déplace radialement vers l'extérieur et dans lequel la gravure est terminée avant que la couche intermédiaire entière (21-24) soit oxydée, formant de ce fait lesdites ouvertures (40) qui sont chacune limitées par au moins trois fronts d'oxydation.

3. Procédé selon l'une quelconque des revendications précédentes
dans lequel au moins une des ouvertures (40) a une forme de type losange où chaque côté est formé par un arc circulaire ou elliptique.

4. Procédé selon l'une quelconque des revendications précédentes
dans lequel au moins une des ouvertures (40) a une forme de type triangle où chaque côté est formé par un arc circulaire ou elliptique.

5. Procédé selon l'une quelconque des revendications précédentes

dans lequel l'au moins une première ouverture (40) est allongée le long d'une première direction (A1) ;
dans lequel l'au moins une deuxième ouverture (40) est allongée le long d'une deuxième direction (A2) ; et
dans lequel les première et deuxième directions (A1, A2) forment un angle l'une par rapport à l'autre.

6. Procédé selon la revendication 5 dans lequel l'axe longitudinal de la première ouverture (40) est orienté perpendiculairement à l'axe longitudinal de la deuxième ouverture (40).

7. Procédé selon la revendication 5 dans lequel l'axe longitudinal de la première ouverture (40) forme un angle de 60° par rapport à l'axe longitudinal de la deuxième ouverture (40).

8. Procédé selon l'une quelconque des revendications précédentes dans lequel,
dans chaque portion (M1) de la mesa (M), au moins deux ouvertures (40) sont fabriquées, lesquelles ont la même orientation.

9. Procédé selon l'une quelconque des revendications précédentes

dans lequel les ouvertures (40) dans la première portion (M1) de la mesa (M) sont orientées le long de la même première direction (A1) ; et
dans lequel les ouvertures (40) dans la deuxième portion (M2) de la mesa (M) sont orientées le long de la même deuxième direction (A2) qui diffère de la première direction (A1).

10. Procédé selon l'une quelconque des revendications précédentes

dans lequel ladite tranchée (TR) définit une troisième portion (M3) de la mesa (M) en plus desdites première et deuxième portions (M1, M2),
dans lequel les ouvertures (40) dans la première portion (M1) sont orientées le long de la même première direction (A1) ;
dans lequel les ouvertures (40) dans la deuxième portion (M2) sont orientées le long de la même deuxième direction (A2) ;
dans lequel les ouvertures (40) dans la troisième portion (M3) sont orientées le long de la même troisième direction (A3) ; et
dans lequel les première, deuxième et troisième directions diffèrent.

11. Procédé selon l'une quelconque des revendications précédentes

dans lequel la première portion (M1) de la mesa (M) est pourvue d'une première couche de réglage d'atténuation optique (200) qui est fabriquée au-dessus de l'empilement de couches (10) ;
dans lequel la deuxième portion (M1) de la mesa (M) est pourvue d'une deuxième couche de réglage d'atténuation optique (210) qui est fabriquée au-dessus de l'empilement de couches (10) ; et
dans lequel les caractéristiques de la première couche d'atténuation optique diffèrent des caractéristiques de la deuxième couche d'atténuation optique.

**12.** Procédé selon l'une quelconque des revendications précédentes

dans lequel l'empilement de couches (10) comprend au moins deux couches intermédiaires (21-24) ;
dans lequel au moins une des couches intermédiaires (21-24) est formée à l'intérieur du premier réflecteur ou entre le premier réflecteur et la région active (13) et
dans lequel au moins une des couches intermédiaires (21-24) est formée à l'intérieur du deuxième réflecteur ou entre le deuxième réflecteur et la région active (13).

**13.** Procédé selon l'une quelconque des revendications précédentes
dans lequel la mesa (M) incluant toutes les ouvertures (40) de la mesa (M) est couplée optiquement à une seule et même fibre (MMF).

Fig.1

Fig.2

Fig.3 a

Fig.3 b

Fig.4

Fig.5

Fig.6

Fig.7

Fig.8

Fig.9

Fig.10

Fig.11

Fig.12

Fig.13

Fig.14

Fig.15

Fig.16

Fig.17

EP 4 007 092 B1

Fig. 18

Fig. 19

Fig.21

Fig.20

Fig.23

Fig.25

Fig.22

Fig.24

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160352073 A1

- US 20010043629 A

**Non-patent literature cited in the description**

- **LARISCH et al.** *Optics Express,* 2020, vol. 28, 6